(19) **Europäisches Patentamt**
**European Patent Office**
**Office européen des brevets**

(11) **EP 3 522 225 A1**

(12) **EUROPEAN PATENT APPLICATION**
published in accordance with Art. 153(4) EPC

(43) Date of publication:
**07.08.2019 Bulletin 2019/32**

(21) Application number: **17856506.5**

(22) Date of filing: **29.09.2017**

(51) Int Cl.:
*H01L 27/146* (2006.01)    *G02B 7/34* (2006.01)
*G03B 13/36* (2006.01)    *H04N 5/232* (2006.01)
*H04N 5/347* (2011.01)    *H04N 5/369* (2011.01)
*H04N 5/374* (2011.01)

(86) International application number:
**PCT/JP2017/035750**

(87) International publication number:
**WO 2018/062559 (05.04.2018 Gazette 2018/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **29.09.2016 JP 2016192252**

(71) Applicant: **Nikon Corporation
Tokyo 108-6290 (JP)**

(72) Inventors:
• **NAKAYAMA, Satoshi
Tokyo 108-6290 (JP)**
• **ANDO, Ryoji
Tokyo 108-6290 (JP)**

(74) Representative: **Hoffmann Eitle
Patent- und Rechtsanwälte PartmbB
Arabellastraße 30
81925 München (DE)**

(54) **IMAGING ELEMENT, FOCUS DETECTION APPARATUS, AND ELECTRONIC CAMERA**

(57)    An image sensor, having a first pixel and a second pixel arranged therein, the first pixel includes: a micro lens into which a first light flux and a second light flux having passed through an image-forming optical system enter; a first photoelectric conversion unit into which the first light flux and the second light flux having transmitted through the micro lens enter; a reflection unit that reflects the first light flux having transmitted through the first photoelectric conversion unit toward the first photoelectric conversion unit; and a second photoelectric conversion unit into which the second light flux having transmitted through the first photoelectric conversion unit enters; and a second pixel comprises: a microlens into which a first light flux and a second light flux having passed through an image-forming optical system enter; a first photoelectric conversion unit into which the first light flux and the second light flux having transmitted through the microlens enter; a reflection unit that reflects the second light flux having transmitted through the first photoelectric conversion unit toward the first photoelectric conversion unit; and a second photoelectric conversion unit into which the first light flux having transmitted through the first photoelectric conversion unit enters.

FIG. 3

EP 3 522 225 A1

## Description

TECHNICAL FIELD

The present invention relates to an image sensor, a focus detection apparatus, and an electronic camera.

BACKGROUND ART

An image-capturing apparatus is known in which a reflection layer is provided under a photoelectric conversion unit to reflect light having transmitted through the photoelectric conversion unit, back to the photoelectric conversion unit (PTL1). This image-capturing apparatus is not able to obtain phase difference information of a subject image.

CITATION LIST

PATENT LITERATURE

PTL1: Japanese Laid-Open Patent Publication No. 2010-177704

SUMMARY OF INVENTION

SOLUTION TO PROBLEM

According to the first aspect of the present invention, an image sensor has a first pixel and a second pixel arranged therein, the first pixel comprises: a microlens into which a first light flux and a second light flux having passed through an image-forming optical system enter; a first photoelectric conversion unit into which the first light flux and the second light flux having transmitted through the microlens enter; a reflection unit that reflects the first light flux having transmitted through the first photoelectric conversion unit toward the first photoelectric conversion unit; and a second photoelectric conversion unit into which the second light flux having transmitted through the first photoelectric conversion unit enters; and a second pixel comprises: a microlens into which a first light flux and a second light flux having passed through an image-forming optical system enter; a first photoelectric conversion unit into which the first light flux and the second light flux having transmitted through the micro lens enter; a reflection unit that reflects the second light flux having transmitted through the first photoelectric conversion unit toward the first photoelectric conversion unit; and a second photoelectric conversion unit into which the first light flux having transmitted through the first photoelectric conversion unit enters.

According to the second aspect of the present invention, a focus detection apparatus comprises: the image sensor according to the first aspect; and a focus detection unit that performs focus detection of the image-forming optical system based on a signal from the first photoelectric conversion unit of the first pixel and a signal from the first photoelectric conversion unit of the second pixel.

According to the third aspect of the present invention, an electronic camera comprises: the image sensor according to the first aspect; and a correction unit that corrects, based on a signal from the second photoelectric conversion unit, a signal from the first photoelectric conversion unit.

BRIEF DESCRIPTION OF DRAWINGS

Fig. 1 is a view showing an example of a configuration of an image-capturing apparatus according to a first embodiment.
Fig. 2 is a view showing an example of an arrangement of pixels of an image sensor according to the first embodiment.
Fig. 3 is a conceptual view showing an example of a configuration of a pixel group of the image sensor according to the first embodiment.
Fig. 4 is a view showing a list of photoelectric conversion signals of the image sensor according to the first embodiment.
Fig. 5 is a circuit diagram showing an example of a configuration of the image sensor according to the first embodiment.
Fig. 6 is a view showing an example of a cross-sectional structure of the image sensor according to the first embodiment.
Fig. 7 is a view showing an example of a configuration of the image sensor according to the first embodiment.
Fig. 8 is a view showing an example of a cross-sectional structure of an image sensor according to a first variation.

DESCRIPTION OF EMBODIMENTS

First Embodiment

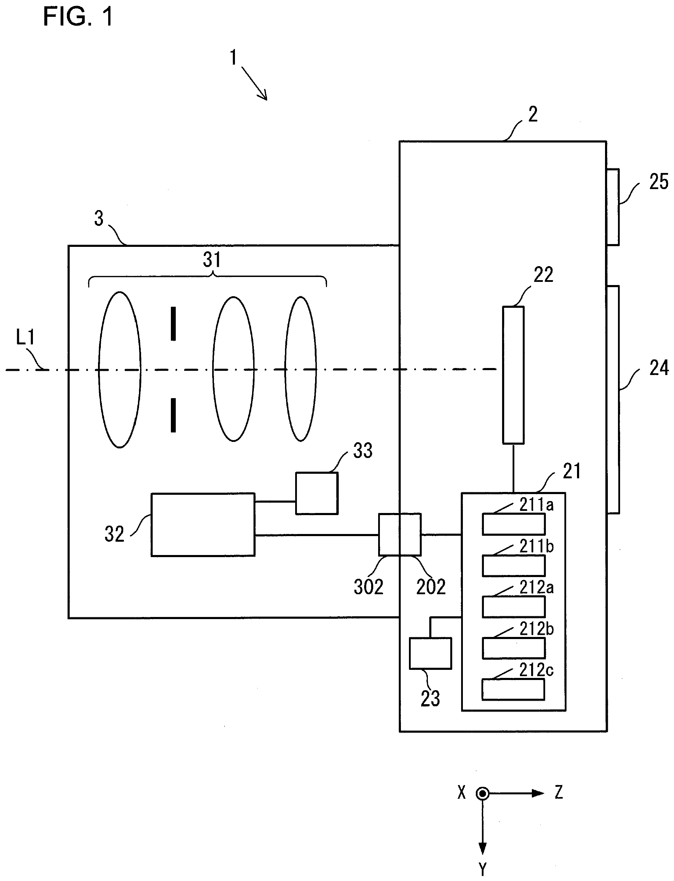

Fig. 1 is a view showing an example of a configuration of an electronic camera 1 (hereinafter referred to as a camera 1) which is an example of an image-capturing apparatus according to a first embodiment. The camera 1 includes a camera body 2 and an interchangeable lens 3. The interchangeable lens 3 is removably attached to the camera body 2 via a mounting unit (not shown). By attaching the interchangeable lens 3 to the camera body 2, a connection unit 202 of the camera body 2 and a connection unit 302 of the interchangeable lens 3 are connected to each other to allow communication between the camera body 2 and the interchangeable lens 3.

In Fig. 1, light from a subject enters in the positive Z-axis direction of Fig. 1. Further, as denoted by the coordinate axes, a direction toward the front side of the paper plane orthogonal to the Z-axis is defined as positive X-axis direction, and a downward direction orthogonal to the Z-axis and the X-axis is defined as negative Y-axis direction. Several following figures have coordinate axes with reference to the coordinate axes of Fig. 1 to indicate the orientation of the figures.

The interchangeable lens 3 includes an image-capturing optical system (image-forming optical system) 31, a lens control unit 32, and a lens memory 33. The image-capturing optical system 31 includes a plurality of lenses including a focus adjustment lens (focus lens) and an aperture and forms a subject image on an image-capturing surface of an image sensor 22 of the camera body 2.

Based on a signal outputted from a body control unit 21 of the camera body 2, the lens control unit 32 moves the focus adjustment lens back and forth in an optical axis L1 direction to adjust a focal position of the image-capturing optical system 31. The signal outputted from the body control unit 21 includes information on a movement direction, a movement amount, a movement speed, and the like of the focus adjustment lens. Further, based on the signal outputted from the body control unit 21 of the camera body 2, the lens control unit 32 controls an opening diameter of the aperture.

The lens memory 33 includes, for example, a nonvolatile storage medium or the like. The lens memory 33 stores information relating to the interchangeable lens 3 as lens information. The lens information includes, for example, information on a position of an exit pupil of the image-capturing optical system 31. Writing and reading of lens information to/from the lens memory 33 are performed by the lens control unit 32.

The camera body 2 includes the body control unit 21, the image sensor 22, a memory 23, a display unit 24, and an operation unit 25. The body control unit 21 includes a CPU, a ROM, a RAM, and the like to control components of the camera 1 based on a control program. The body control unit 21 also performs various types of signal processing.

The image sensor 22 is, for example, a CMOS image sensor or a CCD image sensor. The image sensor 22 receives a light flux that has passed through the exit pupil of the image-capturing optical system 31, to capture a subject image. In the image sensor 22, a plurality of pixels having photoelectric conversion units are arranged two-dimensionally (for example, in row and column directions). The photoelectric conversion unit includes, for example, a photodiode (PD). The image sensor 22 photoelectrically converts the incident light to generate a signal, and outputs the generated signal to the body control unit 21. As will be described later in detail, the image sensor 22 outputs a signal for generating image data (i.e., an image signal) and a pair of focus detection signals for performing phase difference type focus detection for the focal point of the image-capturing optical system 31 (i.e., first and second focus detection signals) to the body control unit 21. As will be described in detail later, the first and second focus detection signals are signals generated by photoelectric conversion of first and second images formed by first and second light fluxes that have passed through, respectively, first and second regions of the exit pupil of the image-capturing optical system 31.

The memory 23 is, for example, a recording medium such as a memory card. The memory 23 records image data and the like. Writing and reading of data to/from the memory 23 are performed by the body control unit 21. The display unit 24 displays images based on image data, information on photographing, such as a shutter speed and an aperture value, a menu screen, and the like. The operation unit 25 includes, for example, various setting switches such as a release button and a power switch and outputs an operation signal corresponding to each operation to the body control unit 21.

The body control unit 21 includes an image data generation unit 211a, a correction unit 211b, a first focus detection unit 212a, a second focus detection unit 212b, and a third focus detection unit 212c. In the following description, each of the first focus detection unit 212a, the second focus detection unit 212b, and the third focus detection unit 212c may be simply referred to as a focus detection unit 212, in case they are not distinguished in particular.

The image data generation unit 211a performs various types of image processing on the image signal outputted from the image sensor 22 to generate image data. The image processing includes known image processing such as gradation conversion processing, color interpolation processing, and edge enhancement processing. The correction unit 211b performs correction processing on the focus detection signal outputted from the image sensor 22. The correction unit 211b performs processing of removing a component that is considered as a noise in the focus detection processing from the focus detection signal, as will be described later in detail.

The focus detection unit 212 performs focus detection processing required for automatic focus adjustment (AF) of the image-capturing optical system 31. Specifically, the focus detection unit 212 calculates a defocus amount by a pupil split type phase difference detection scheme using a pair of focus detection signals. More specifically, the focus detection unit 212 detects an image shift amount between the first and second images, based on first and second focus detection signals generated by photoelectric conversion of the first and second images formed by the first and second light fluxes that have passed through the first and second regions of the exit pupil of the image-capturing optical system 31. The focus detection unit 212 calculates the defocus amount based on the detected image shift amount.

The focus detection unit 212 determines whether or not the defocus amount is within an allowable range. If the defocus amount is within the allowable range, the focus detection unit 212 determines that it is in focus. On the other hand, if the defocus amount is out of the allowable range, the focus detection unit 212 determines that it is not in focus, and transmits the defocus amount and a lens drive instruction to the lens control unit 32 of the interchangeable lens 3. Upon reception of the instruction from the focus detection unit 212, the lens control unit 32 drives the focus adjustment lens depending on the defocus amount, so that focus adjustment is automatically performed.

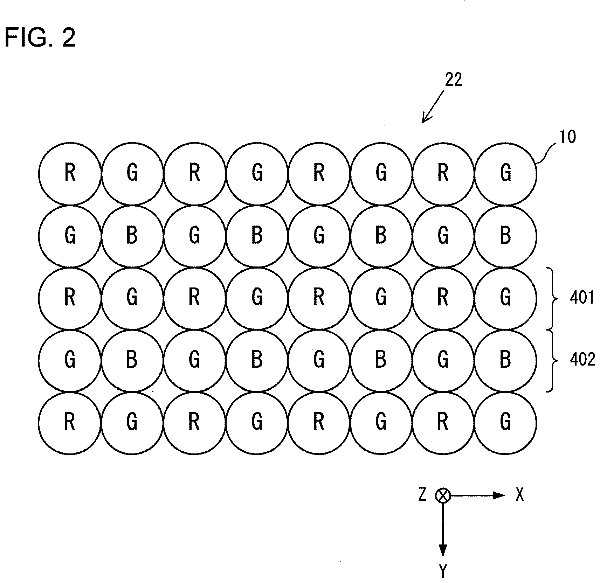

Fig. 2 is a view showing an example of an arrangement of pixels of the image sensor 22 according to the first embodiment. In the example shown in Fig. 2, a total of 40 pixels 10 (5 rows x 8 columns) are shown. Note that the number and arrangement of the pixels arranged in the image sensor 22 are not limited to the illustrated example. The image sensor 22 may be provided with, for example, several million to several hundred million or more pixels.

Each pixel 10 has any one of three color filters having different spectral sensitivities of R (red), G (green), and B (blue), for example. An R color filter mainly transmits light having a first wavelength (light having a red wavelength region), a G color filter mainly transmits light having a wavelength shorter than the first wavelength (light having a green wavelength region), and the B color filter mainly transmits light having a wavelength shorter than the second wavelength (light having a blue wavelength region). As a result, the pixels 10 have different spectral sensitivity characteristics depending on the color filters arranged therein.

The image sensor 22 has a pixel group 401, in which pixels 10 having R color filters (hereinafter referred to as R pixels) and pixels 10 having G color filters (hereinafter referred to as G pixels) are alternately arranged in a first direction, that is, in a row direction. Further, the image sensor 22 has a pixel group 402, in which the G pixels 10 and pixels 10 having B color filters (hereinafter referred to as B pixels) are alternately arranged in a row direction. The pixel group 401 and the pixel group 402 are alternately arranged in a second direction that intersects the first direction, that is, in a column direction. In this way, in the present embodiment, the R pixels 10, the G pixels 10, and the B pixels 10 are arranged in a Bayer array.

The pixel 10 receives light entered through the image-capturing optical system 31 to generate a signal corresponding to an amount of the received light. The signal generated by each pixel 10 is used as the image signal and the first and second focus detection signals, as will be described later in detail.

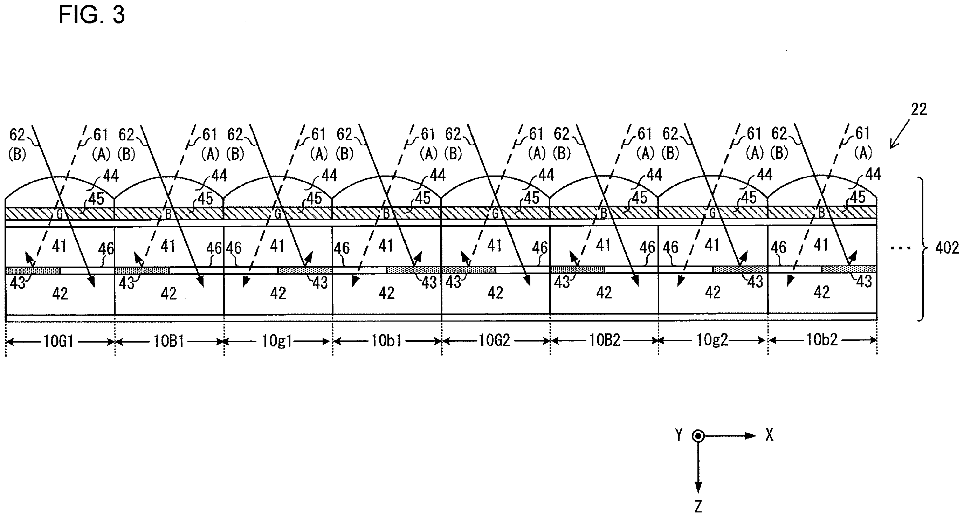

Fig. 3 is a conceptual view showing an example of a configuration of a pixel group 402 of the image sensor 22 according to the first embodiment. The G pixels 10 include two types of G pixels, that is, first G pixels 10G (G pixels 10G1, 10G2 in Fig. 3) and second G pixels 10g (G pixels 10g1, 10g2 in Fig. 3). The first G pixels 10G and the second G pixels 10g are alternately arranged with B pixels interposed therebetween. Further, the B pixels 10 include two types of B pixels, that is, first B pixels 10B (B pixels 10B1, 10B2 in Fig. 3) and second B pixels 10b (B pixels 10b1, 10b2 in Fig. 3), and the first B pixels 10B and the second B pixels 10b are alternately arranged with G pixels interposed therebetween.

Note that the R pixels 10 and the G pixels 10 in the pixel group 401 shown in Fig. 2 also have first R pixels and second R pixels and first G pixels and second G pixels that have respectively the same structure as those of the first and second B pixels 10B, 10b and the first and second G pixels 10G, 10g in the pixel group 402. In other words, the configuration of the first G pixels 10G, the configuration of the first B pixels 10B, and the configuration of the first R pixels are the same except for their color filters. Additionally, the configuration of the second G pixels 10g, the configuration of the second B pixels 10b, and the configuration of the second R pixels are the same except for their color filters. Therefore, the first G pixel 10G and the second G pixel 10g will be described hereinafter as a representative example.

In Fig. 3, each of the first G pixels 10G and the second G pixels 10g includes a first photoelectric conversion unit 41, a second photoelectric conversion unit 42, a reflection unit 43, a micro lens 44, and a color filter 45. The first and second photoelectric conversion units 41, 42 are stacked to each other, are configured to have the same size in the present embodiment, and are separated and insulated from each other. The reflection unit 43 is configured with, for example, a metal reflection film and is provided between the first photoelectric conversion unit 41 and the second photoelectric conversion unit 42. Note that the reflection unit 43 may be configured with an insulating film.

In the first G pixel 10G, the reflection unit 43 is arranged so as to correspond to almost the left half region (on the negative X side of the photoelectric conversion unit 42) of each of the first photoelectric conversion unit 41 and the second photoelectric conversion unit 42. Further, in the first G pixel 10G, insulating films (not shown) are provided between the first photoelectric conversion unit 41 and the reflection unit 43 and between the second photoelectric conversion unit 42 and the reflection unit 43. Further, in the first G pixel 10G, a transparent electrically-insulating film 46 is provided between almost the right half region of the first photoelectric conversion unit 41 and almost the right half region of the second photoelectric conversion unit 42. In this way, the first and second photoelectric conversion units 41, 42 are separated and insulated by the transparent insulating film 46 and the above-described insulating films (not shown).

In the second G pixel 10G, the reflection unit 43 is arranged so as to correspond to almost the right half region (on the positive X side of the photoelectric conversion unit 41) of each of the first photoelectric conversion unit 41 and the second photoelectric conversion unit 42. Further, in the second G pixel 10g, insulating films (not shown) are provided between the first photoelectric conversion unit 41 and the reflection unit 43 and between the second photoelectric conversion unit 42 and the reflection unit 43. Further, in the second G pixel 10g, a transparent electrically-insulating film 46 is provided between almost the left half region of the first photoelectric conversion unit 41 and almost the left half region of the second photoelectric conversion unit 42. In this way, the first and second photoelectric conversion units 41, 42 are separated and insulated by the transparent insulating film 46 and the above-described insulating films (not shown).

The micro lens 44 condenses light entered through the image-forming optical system 3 from above in Fig. 3. Power of the micro lens 44 is determined so that the position of the reflection unit 43 and the position of the exit pupil of the image-forming optical system 3 are in a conjugate positional relationship with respect to the micro lens 44. Since the G pixels 10 and the B pixels 10 in the pixel group 402 are alternately arranged in the X direction, that is, in the row direction as described above, the G color filters 45 and the B color filters 45 are alternately arranged in the X direction.

Next, the light fluxes enter the pixels 10 and the signals generated by the pixels 10 will be described in detail. In the following description, a region of a projected image of the reflection unit 43 of the first G pixel 10G and a region of a projected image of the transparent insulating film 46 of the second G pixel 10g, both are projected onto the exit pupil position of the image-capturing optical system 31 by the microlens 44, are referred to as a first pupil region of the exit pupil of the image-capturing optical system 3. Similarly, a region of a projected image of the transparent insulating film 46 of the first G pixel 10G and a region of a projected image of the reflection film 43 of the second G pixel 10g, both are projected onto a position of the exit pupil of the image-capturing optical system 31 by the microlens 44, are referred to as a second pupil region of the exit pupil of the image-capturing optical system 3.

In the first G pixel 10G, a first light flux 61 indicated by a broken line passing through the first pupil region of the exit pupil of the image-capturing optical system 3 shown in Fig. 1 transmits through the microlens 44, the color filter 45, and the first photoelectric conversion unit 41 and is then reflected from the reflection unit 43 to again enter the first photoelectric conversion unit 41. The second light flux 62 indicated by a solid line passing through the second pupil region of the exit pupil of the image-capturing optical system 3 transmits through the microlens 44, the color filter 45, and the first photoelectric conversion unit 41, and then further transmits through the transparent insulating film 46 to enter the second photoelectric conversion unit 42. In the first G pixel 10G, the transparent insulating film 46 functions as an opening that allows the second light flux 62 having transmitted through the first photoelectric conversion unit 41 to enter the second photoelectric conversion unit 42.

In the first G pixel 10G, since both the first light flux 61 and the second light flux 62 enter the first photoelectric conversion unit 41 in this way, the first photoelectric conversion unit 41 photoelectrically converts the first light flux 61 and the second light flux 62 to generate electric charges. Additionally, the first light flux 61 enters the first photoelectric conversion unit 41 transmits through the first photoelectric conversion unit 41 and is then reflected from the reflection unit 43 to again enter the first photoelectric conversion unit 41. The first photoelectric conversion unit 41 therefore photoelectrically converts the reflected first light flux 61 to generate electric charge.

Thus, the first photoelectric conversion unit 41 of the first G pixel 10G generates the electric charge obtained by photoelectric conversion of the first light flux 61 and the second light flux 62 and the electric charge obtained by photoelectric conversion of the first light flux 61 reflected from the reflection unit 43. The first G pixel 10G outputs a signal based on these electric charges generated by the first photoelectric conversion unit 41 as a first photoelectric conversion signal S1G.

Further, in the first G pixel 10G, the second light flux 62 passes through the transparent insulating film 46 and enters the second photoelectric conversion unit 42 after passing through the first photoelectric conversion unit 41. The second photoelectric conversion unit 42 of the first G pixel 10G thus photoelectrically converts the second light flux 62 to generate electric charge. The first G pixel 10G outputs a signal based on the electric charge generated by the second photoelectric conversion unit 42 as a second photoelectric conversion signal S2G.

In the second G pixel 10g, a first light flux 61 indicated by a broken line passing through the first pupil region of the exit pupil of the image-capturing optical system 3 shown in Fig. 1 transmits through the microlens 44, the color filter 45, and the first photoelectric conversion unit 41 and then further transmits through the transparent insulating film 46 to entero the second photoelectric conversion unit 42. In the second G pixel 10g, the transparent insulating film 46 functions as an opening that allows the first light flux 61 having transmitted through the first photoelectric conversion unit 41 to enter the second photoelectric conversion unit 42. A second light flux 62 indicated by a solid line passing through the second pupil region of the exit pupil of the image-capturing optical system 3 transmits through the microlens 44, the color filter 45, and the first photoelectric conversion unit 41 and is then reflected from the reflection unit 43 to again enter the first photoelectric conversion unit 41.

In the second G pixel 10g, since both the first light flux 61 and the second light flux 62 enter the first photoelectric conversion unit 41 in this way, the first photoelectric conversion unit 41 photoelectrically converts the first light flux 61 and the second light flux 62 to generate electric charges. Additionally, the second light flux 62 entered the first photoelectric conversion unit 41 transmits through the first photoelectric conversion unit 41 and is then reflected from the reflection unit 43 to again enter the first photoelectric conversion unit 41. The first photoelectric conversion unit 41 therefore photoelectrically converts the reflected second light flux 62 to generate electric charge.

Thus, the first photoelectric conversion unit 41 of the second G pixel 10g generates the electric charge obtained by photoelectric conversion of the first light flux 61 and the second light flux 62 and the electric charge obtained by photoelectric conversion of the second light flux 62 reflected from the reflection unit 43. The second G pixel 10g outputs a signal based on the electric charges generated by the first photoelectric conversion unit 41 as a first photoelectric conversion signal S1g.

Further, in the second G pixel 10g, the first light flux 61 passes through the transparent insulating film 46 and enters the second photoelectric conversion unit 42 after passing through the first photoelectric conversion unit 41. The second photoelectric conversion unit 42 thus photoelectrically converts the first light flux 61 to generate electric charge. The second G pixel 10g outputs a signal based on the electric charge generated by the second photoelectric conversion unit 42 as a second photoelectric conversion signal S2g.

Next, magnitudes of the first and second photoelectric conversion signals S1G, S2G outputted from the first G pixel 10G are estimated. A photoelectric conversion signal generated by photoelectric conversion of the first light flux 61 which directly entered the first photoelectric conversion unit 41 is expressed as kaA, supposing that, a light intensity (light amount) of the first light flux 61 which entered the first photoelectric conversion unit 41 is A, a conversion factor in photoelectric conversion of the light flux which entered the first photoelectric conversion unit 41 is k, and an absorption ratio in the first photoelectric conversion unit 41 to light which entered the first photoelectric conversion unit 41 is $\alpha$. Additionally, a light intensity of the first light flux 61 which entered the first photoelectric conversion unit 41 through the micro lens 44 and absorbed in the first photoelectric conversion unit 41 is $\alpha$A. Further, assuming that the first light flux 61 having transmitted through the first photoelectric conversion unit 41 is completely reflected from the reflection unit 43 and again entered the first photoelectric conversion unit 41, a signal based on electric charge generated by photoelectric conversion of the light which again entered the first photoelectric conversion unit 41 is to be k(A-$\alpha$A).

Further, a signal based on electric charge generated by photoelectric conversion of the second light flux 62 which directly entered the first photoelectric conversion unit 41 is kaB, supposing that a light intensity (light amount) of the second light flux 62 which entered the first photoelectric conversion unit 41 is B. The first photoelectric conversion signal S1G based on the electric charge converted by the first photoelectric conversion unit 41 can thus be represented by the following expression.

$$S1G = k\alpha A + k(A-\alpha A) + k\alpha B$$
$$= k(1-\alpha)A + k\alpha A + k\alpha B \ ... \ \text{Expression (1)}$$

As described above, in expression (1), k(1-$\alpha$)A represents a photoelectric conversion signal generated by photoelectric conversion of the first light flux 61 that was reflected from the reflection unit 43 and again entered the first photoelectric conversion unit 41.

A light intensity of the second light flux 62 that enters the first photoelectric conversion unit 41 through the micro lens 44 and is absorbed by the first photoelectric conversion unit 41 is to be $\alpha$B. Further, supposing that, a conversion factor in photoelectric conversion of the light flux enters the second photoelectric conversion unit 42 is set to have the same value k as that of the conversion factor of the first photoelectric conversion unit 41. In the first G pixel 10G, the second light flux 62 having transmitted through the first photoelectric conversion unit 41 completely enters the second photoelectric conversion unit 42. The second photoelectric conversion signal S2G based on the electric charge generated by photoelectric conversion of the second light flux 62 in the second photoelectric conversion unit 42 can thus be represented by the following expression.

$$S2G = k(B-\alpha B)$$
$$= k(1-\alpha)B \ ... \ \text{Expression (2)}$$

Next, magnitudes of the first and second photoelectric conversion signals S1g, S2g outputted from the second G pixel 10g are estimated. The first and second photoelectric conversion signals S1g, S2g of the second G pixel 10g are represented by the following expressions (3) and (4) in which A and B in the above expressions (1) and (2) are replaced each other.

$$S1g = k(1-\alpha)B + k\alpha A + k\alpha B \ ... \ \text{Expression (3)}$$

$$S2g = k(1-\alpha)A \ ... \ \text{Expression (4)}$$

The first and second photoelectric conversion signals S1, S2 of the first and second B pixels and R pixels are the same as in the case of the first and second G pixels 10G, 10g.

Each of the first focus detection unit 212a to the third focus detection unit 212c shown in Fig. 1 detects an image shift between the first image formed by the first light flux 61 and the second image formed by the second light flux 62 as a phase difference between the first focus detection signal generated by photoelectric conversion of the first image and the second focus detection signal generated by photoelectric conversion of the second image.

Here, the first photoelectric conversion signal S1G based on the electric charges generated by the first photoelectric conversion unit 41 of the first G pixel 10G is a signal obtained by adding the signal generated by photoelectrical conversion of the first light flux 61 reflected from the reflection unit 43 and the signals generated by photoelectric conversion of the first and second light fluxes 61, 62 entered the first photoelectric conversion unit 41 as described above. It is thus necessary to remove the photoelectric conversion signal generated by photoelectric conversion of the first and second light fluxes 61, 62 entered the first photoelectric conversion unit 41, that is, (kaA+kaB) shown in expression (1), as a noise component, from the first photoelectric conversion signal S1G.

For this purpose, the correction unit 211b of the body control unit 21 performs correction processing for eliminating the noise component from the first photoelectric conversion signal S1G. Values of the conversion factor k for the first photoelectric conversion unit 41 and the absorption ratio $\alpha$ of the first photoelectric conversion unit 41 are known values determined by a quantum efficiency of the first photoelectric conversion unit 41, a thickness of the substrate thereof, and the like. Then, the body control unit 21 calculates the light intensities A, B of the first and second light fluxes 61, 62 using expressions (1) and (2), and calculates the noise component (kaA+kaB) based on the calculated light intensities A, B.

The correction unit 211b subtracts the calculated noise component (kaA+kaB) from the first photoelectric conversion signal S1G to calculate $k(1-\alpha)A$. In other words, the correction unit 211b removes the noise component (kaA+kaB) from the first photoelectric conversion signal S1G and extracts a signal component $k(1-\alpha)A$ based on the first light flux 61 that has been reflected from the reflection unit 43 and again entered the first photoelectric conversion unit 41, as the corrected first photoelectric conversion signal S1G'. Thus, the corrected first photoelectric conversion signal S1G' can be represented by the following expression (5).

$$S1G'=k(1-\alpha)A \ ... \ \text{Expression (5)}$$

Further, the first photoelectric conversion signal S1g based on the electric charges generated by the first photoelectric conversion unit 41 of the second G pixel 10g is a signal obtained by adding the signal generated by photoelectrical conversion of the second light flux 62 reflected from the reflection unit 43 and the signals generated by photoelectric conversion of the first and second light fluxes 61, 62 entered the first photoelectric conversion unit 41 as described above. It is thus necessary to remove the photoelectric conversion signal generated by photoelectric conversion of the first and second light fluxes 61, 62 entered the first photoelectric conversion unit 41, that is, (kaA+kaB) shown in expression (3), as a noise component, from the first photoelectric conversion signal S1g.

Then, the body control unit 21 calculates the light intensities A, B of the first and second light fluxes 61, 62 using expressions (3) and (4), and calculates the noise component (kaA+kaB) based on the calculated light intensities A, B. The correction unit 211b subtracts the calculated noise component (kaA+kaB) from the first photoelectric conversion signal S1g to extract a signal component $k(1-\alpha)B$ based on the second light flux 62 that has been reflected from the reflection unit 43 and again entered the first photoelectric conversion unit 41, as the corrected first photoelectric conversion signal S1g'. Thus, the corrected first photoelectric conversion signal S1g' can be represented by the following expression (6).

$$S1g'=k(1-\alpha)B \ ... \ \text{Expression (6)}$$

Note that values of the conversion factors k for the first and second photoelectric conversion units 41, 42 and the absorption ratio $\alpha$ of the first photoelectric conversion unit 41 depend on the quantum efficiencies of the first and second photoelectric conversion units 41, 42, the thicknesses of the substrate thereof, and the like; thus, these values can be calculated in advance. The values of the conversion factor k and the absorption ratio $\alpha$ are recorded in a memory or the like in the body control unit 21.

In Fig. 3, light intensities of the first light fluxes 61 respectively enter the first and second G pixels 10G1, 10g1, 10G2, 10g2 are indicated by A1, A2, A3, A4, respectively, and light intensities of the second light fluxes 62 are indicated by B1, B2, B3, B4, respectively. In this case, in the first G pixel 10G1, the corrected first photoelectric conversion signal S1G' is to be $k(1-\alpha)A1$ and the second photoelectric conversion signal S2G is to be $k(1-\alpha)B1$. Similarly, in the second G pixel 10g1, the corrected first photoelectric conversion signal S1g' is to be $k(1-\alpha)B2$ and the second photoelectric conversion signal S2g is to be $k(1-\alpha)A2$. In the first G pixel 10G2, the corrected first photoelectric conversion signal S1G' is to be $k(1-\alpha)A3$ and the second photoelectric conversion signal S2G is to be $k(1-\alpha)B3$. In the second G pixel 10g2, the corrected first photoelectric conversion signal S1g' is to be $k(1-\alpha)B4$ and the second photoelectric conversion signal S2g is to be $k(1-\alpha)A4$.

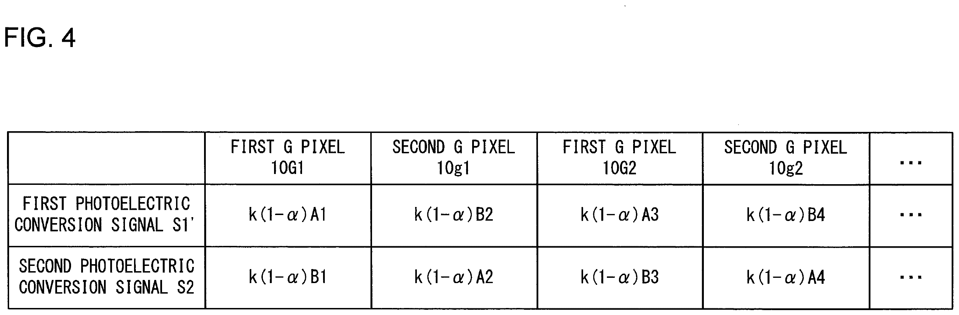

Fig. 4 shows a list of corrected first photoelectric conversion signals and second photoelectric conversion signals, respectively of the first G pixel 10G1, the second G pixel 10g1, the first G pixel 10G2, and the second G pixel 10g2.

The first focus detection unit 212a uses the first photoelectric conversion signals S1G of the first G pixels 10G1, 10G2, ... as first focus detection signals, and the first photoelectric conversion signals S1g of the second G pixels 10g1, 10g2, ... as second focus detection signals, to perform focus detection.

In other words, in Fig. 4, the first focus detection unit 212a uses k(1-α)A1 and k(1-α)A3 as uses the first focus detection signals and k(1-α)B2 and k(1-α)B4 as the second focus detection signals.

Note that, in Fig. 3, the first focus detection unit 212a performs phase difference type focus detection based on the first and second focus detection signals from the plurality of G pixels 10 arranged in every other pixel, and performs phase difference type focus detection based on the first and second focus detection signals from the plurality of B pixels 10 arranged in every other pixel. Similarly, the first focus detection unit 212a performs phase difference type focus detection based on the first and second focus detection signals from the plurality of R pixels 10 arranged in every other pixel in the pixel group 401 shown in Fig. 2 and performs phase difference type focus detection based on the first and second focus detection signals from the plurality of G pixels 10 arranged in every other pixel in the pixel group 401 shown in Fig. 2.

The second focus detection unit 212b shown in Fig. 1 uses the second photoelectric conversion signals S2g of the second G pixels 10g1, 10g2, ... as a first focus detection signals, and uses the second photoelectric conversion signal S2G of the first G pixels 10G1, 10G2, ... as a second focus detection signals, to perform focus detection.

In other words, in Fig. 4, the second focus detection unit 212b uses k(1-α)A2 and k(1-α)A4 as the first focus detection signals and uses k(1-α)B1 and k(1-α)B3 as the second focus detection signals,. The second focus detection unit 212b calculates the defocus amount of the image-capturing optical system 31 based on the first focus detection signasl and the second focus detection signals.

Note that in Fig. 3, the second focus detection unit 212b performs phase difference type focus detection based on the first and second focus detection signals from the plurality of G pixels 10 arranged in every other pixel and performs phase difference type focus detection based on the first and second focus detection signals from the plurality of B pixels 10 arranged in every other pixel. Similarly, the second focus detection unit 212b performs phase difference type focus detection based on the first and second focus detection signals from the plurality of R pixels 10 arranged in every other pixel in the pixel group 401 shown in Fig. 2 and performs phase difference type focus detection based on the first and second focus detection signals from the plurality of G pixels 10 arranged in every other pixel in the pixel group 401 shown in Fig. 2.

The third focus detection unit 212c shown in Fig. 1 uses the first photoelectric conversion signals S1G of the first G pixels 10G1, 10G2, ... and the second photoelectric conversion signals S2g of the second G pixels 10g1, 10g2, ... as a first focus detection signals for focus detection processing. Further, the third focus detection unit 212c uses the second photoelectric conversion signals S2G of the first G pixels 10G1, 10G2, ... and the first photoelectric conversion signals S1g of the second G pixels 10g1, 10g2, ... as a second focus detection signal for focus detection processing.

In other words, in Fig. 4, the third focus detection unit 212c uses k(1-α)A1, k(1-α)A2, and k(1-α)A3 as the first focus detection signals and uses k(1-α)B1, k(1-α)B2, k(1-α)B3, and k(1-α)B4 as the second focus detection signals. The third focus detection unit 212c calculates the defocus amount of the image-capturing optical system 31 based on the first focus detection signals and the second focus detection signals.

Based on the defocus amount calculated by each of the first focus detection unit 212a to the third focus detection unit 212c, the lens control unit 32 moves the focus adjustment lens of the image-capturing optical system 31 to the focus position to adjust the focal point. For example, based on information on the frequency of a subject image, the lens control unit 32 selects a defocus amount to be used for focus adjustment among defocus amounts calculated by the first focus detection unit 212a to the third focus detection unit 212c. Then, the lens control unit 32 performs focus adjustment using the defocus amount calculated by the selected focus detection unit.

Next, the image data generation unit 211a of the body control unit 21 shown in Fig. 1 will be described. The image data generation unit 211a of the body control unit 21 adds the first photoelectric conversion signal S1G and the second photoelectric conversion signal S2G of the first G pixel 10G to generate the image signal S3G. In other words, the image signal S3G is represented by the following expression (7) which is derived by adding the first photoelectric conversion signal S1G of expression (1) and the second photoelectric conversion signal S2G of expression (2).

$$S3G=k(A+B) \ldots \text{Expression (7)}$$

Further, the image data generation unit 211a adds the first photoelectric conversion signal S1g and the second photoelectric conversion signal S2g of the second G pixel 10g to generate the image signal S3g. In other words, the image signal S3g is represented by the following expression (8) which is derived by adding the first photoelectric conversion signal S1g of expression (3) and the second photoelectric conversion signal S2g of expression (4).

$$S3g=k(A+B) \ldots \text{Expression (8)}$$

Thus, each of the image signal S3G and the image signal S3g has a value related to a value obtained by adding the light intensities A and B which are respectively the first and second light fluxes 61, 62 that have passed through the first and second pupil regions of the image-capturing optical system 3, respectively. The image data generation unit 211a generates image data based on the image signal S3G and the image signal S3g.

Note that in the present embodiment, each signal level of the photoelectric conversion signal S1G, S1g has a significantly improved, compared with those of a conventional image sensor, that is, an image sensor having no reflection unit. Specifically, in case the first and second light fluxes 61, 62 are received by the photoelectric conversion unit, a photoelectric conversion signal from the photoelectric conversion unit is to be $k\alpha(A+B)$. On the other hand, the photoelectric conversion signals in the present embodiment are to be $k(1-\alpha)A+k\alpha A+k\alpha B$ and $k(1-\alpha)B+k\alpha A+k\alpha B$ as shown in expressions (1) and (3). The photoelectric conversion signals S1G and S1g in the present embodiment are respectively larger than $k\alpha(A+B)$ by $k(1-\alpha)A$ and $k(1-\alpha)B$.

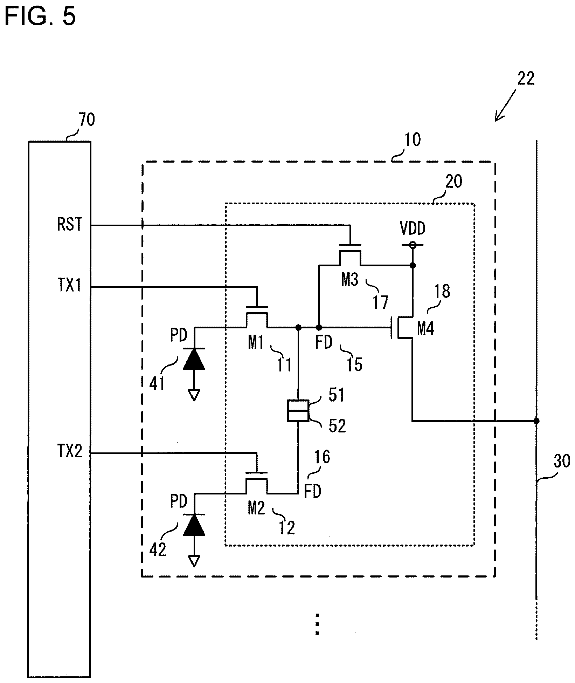

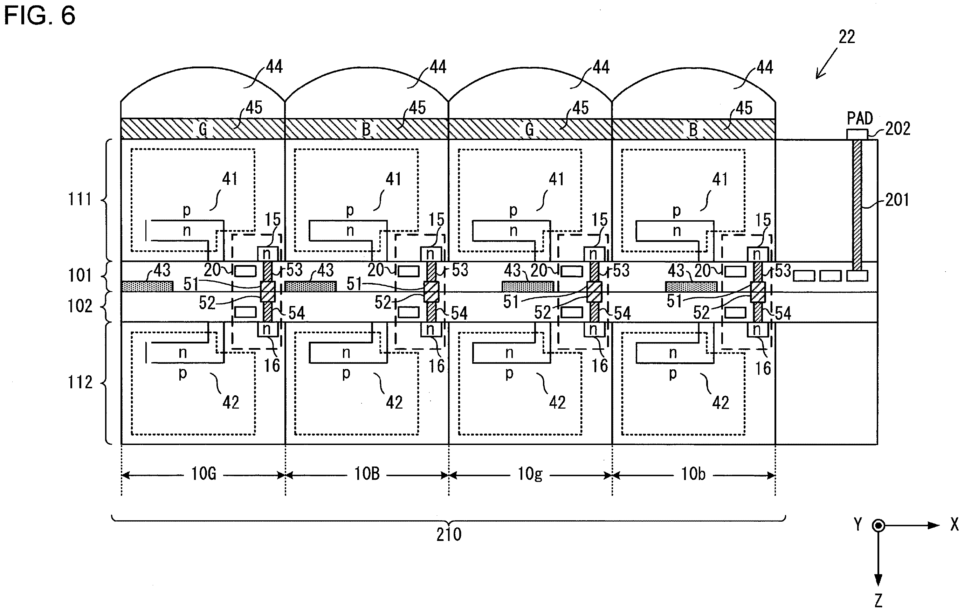

Additionally, in the above description, the image signal S3G and the image signal S3g are generated by adding the first photoelectric conversion signal S1 and the second photoelectric conversion signal S2 in the image data generation unit 211a of the body control unit 21. However, the addition of the first photoelectric conversion signal S1 and the second photoelectric conversion signal S2 may be performed in the image sensor 22 as will be described later in detail with reference to Figs. 5 and 6. Further, the image data generation unit 211a may use only the first photoelectric conversion signal S1 as the image signal. In this case, the correction unit 211b may subtract the signal component $k(1-\alpha)A$ of expression (1) from the first photoelectric conversion signal S1G and subtract the signal component $k(1-\alpha)B$ of expression (3) from the first photoelectric conversion signal S1g.

Fig. 5 is a circuit diagram showing an example of a configuration of the image sensor 22 according to the first embodiment. The image sensor 22 includes a plurality of pixels 10 and a pixel vertical drive unit 70. The pixel 10 includes the first photoelectric conversion unit 41 and the second photoelectric conversion unit 42, which are described above, and a readout unit 20. The readout unit 20 includes a first transfer unit 11, a second transfer unit 12, a first floating diffusion (hereinafter referred to as FD) 15, a second FD 16, a reset unit 17, an amplification unit 18, and first and second connection units 51, 52. The pixel vertical drive unit 70 supplies control signals such as a signal TX1, a signal TX2, and a signal RST to each pixel 10 to control operations of each pixel 10. Note that in the example shown in Fig. 5, only one pixel is shown for simplicity of explanation.

The first transfer unit 11 is controlled with the signal TX1 so as to transfer electric charge generated by photoelectric conversion in the first photoelectric conversion unit 41 to the first FD 15. In other words, the first transfer unit 11 forms a charge transfer path between the first photoelectric conversion unit 41 and the first FD 15. The second transfer unit 12 is controlled with the signal TX2 so as to transfer electric charge generated by photoelectric conversion in the second photoelectric conversion unit 42 to the second FD 16. In other words, the second transfer unit 12 forms a charge transfer path between the second photoelectric conversion unit 42 and the second FD 16. The first FD 15 and the second FD 16 are electrically connected via connection units 51, 52 to hold (accumulate) electric charges, as described later with reference to Fig. 6.

The amplification unit 18 amplifies and outputs a signal based on the electric charges held in the first FD 15 and the second FD 16. The amplification unit 18 is connected to a vertical signal line 30 and functions as a part of a source follower circuit which is operated by a current source (not shown) as a load current source. The reset unit 17 is controlled by a signal RST and resets the electric charges of the first FD 15 and the second FD 16 to reset potentials of the first FD 15 and the second FD 16 to a reset potential (reference potential). The first transfer unit 11, the second transfer unit 12, the discharge unit 17, and the amplification unit 18 include a transistor M1, a transistor M2, a transistor M3, and a transistor M4, respectively, for example.

By setting the signal TX1 to high level and the signal TX2 to low level, the transistor M1 becomes on state and the transistor M2 becomes off state. As a result, the electric charges generated by the first photoelectric conversion unit 41 are transferred to the first FD 15 and the second FD 16. The readout unit 20 reads out a signal based on the electric charges generated by the first photoelectric conversion unit 41, that is, the first photoelectric conversion signal S1 to the vertical signal line 30. By setting the signal TX1 to low level and the signal TX2 to high level, the transistor M1 becomes off state and the transistor M2 becomes on state. As a result, the electric charges generated by the second photoelectric conversion unit 42 are transferred to the first FD 15 and the second FD 16. The readout unit 20 reads out a signal based on the electric charges accumulated by the second photoelectric conversion unit 42, that is, the second photoelectric conversion signal S2 to the vertical signal line 30.

Further, by setting both the signal TX1 and the signal TX2 to high level, both of the electric charges generated by the first photoelectric conversion unit 41 and the second photoelectric conversion unit 42 are transferred to the first FD 15 and the second FD 16. Thus, the readout unit 20 reads out an added signal generated by adding the electric charge generated by the first photoelectric conversion unit 41 and the electric charge generated by the second photoelectric conversion unit 42, that is, the image signal S3 to the vertical signal line 30. In this way, the pixel vertical drive unit 70 can sequentially output the first photoelectric conversion signal S1 and the second photoelectric conversion signal S2 by performing on/off control of the first transfer unit 11 and the second transfer unit 12. Additionally, the pixel vertical drive unit 70 can output the image signal S3 by adding the electric charge generated by the first photoelectric conversion unit 41 and the electric charge generated by the second photoelectric conversion unit 42.

Note that in case the image signal S3 is read out by setting both the signal TX1 and the signal TX2 to high level, it is not necessarily required that the signals TX1 and TX2 are simultaneously set to high level. In other words, the electric charge generated by the first photoelectric conversion unit 41 and the electric charge generated by the second photoelectric conversion unit 42 can be added even if a timing of setting the signal TX1 to high level and a timing of setting the signal TX2 to high level are shifted to each other.

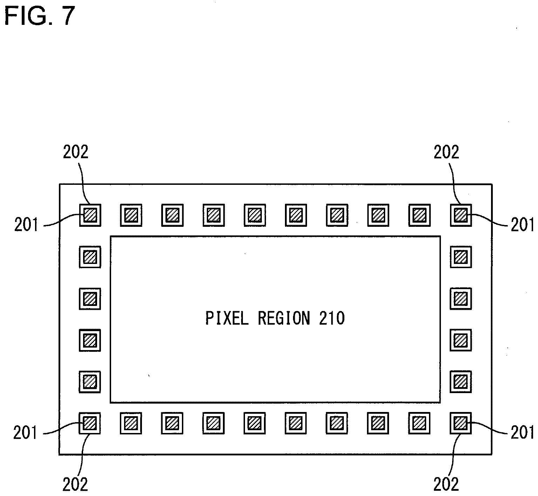

Fig. 6 is a view showing an example of a cross-sectional structure of the image sensor 22 according to the first embodiment. Fig. 7 is a view showing an example of a configuration of the image sensor 22 according to the first embodiment. The image sensor 22 includes a first substrate 111 and a second substrate 112. The first substrate 111 and the second substrate 112 each comprise a semiconductor substrate. The first substrate 111 has a wiring layer 101 stacked thereon and the second substrate 112 has a wiring layer 102 stacked thereon. Each of the wiring layer 101 and the wiring layer 102 includes a conductor film (metal film) and an insulating film. A plurality of wires, vias, contacts, and the like are arranged therein. The conductor film is formed by, for example, copper, aluminum, or the like. The insulating film is formed by, for example, an oxide film, a nitride film, or the like. As shown in Figs. 6 and 7, a plurality of through electrodes 201 are provided around a pixel region 210 where the pixels 10 are arranged. Further, electrode PADs 202 are provided so as to correspond to the through electrodes 201. Fig. 6 shows the example in which the through electrodes 201 and the electrode PADs 202 are provided on the first substrate 111; however, the through electrodes 201 and the electrode PADs 202 may be provided on the second substrate 112. Although only four pixels 10 are illustrated in Fig. 6, it may be provided with, for example, several million to several hundred million or more pixels 10 in the pixel region 210.

As described above, the pixel 10 is provided with the first photoelectric conversion unit 41, the second photoelectric conversion unit 42, the reflection unit 43, the microlens 44, the color filter 45, and the readout unit 20. The first FD 15 and the second FD 16 of the readout unit 20 are electrically connected via contacts 53, 54 and the connection units 51, 52. The connection unit 51 and the connection unit 52 are bumps, electrodes, or the like.

A signal of each pixel 10 outputted from the readout unit 20 to the vertical signal line 30 shown in Fig. 5 are subjected to signal processing such as A/D conversion by an arithmetic circuit (not shown) provided on the first substrate 111, for example. The arithmetic circuit reads out the signal of each pixel 10 that the signal processing was carried to the body control unit 21 via the through electrodes 201 and the electrode PADs 202.

Next, operations according to the present embodiment will be described. In the electronic camera 1, by operating a power switch by the operation unit 25, the first photoelectric conversion signal S1, the second photoelectric conversion signal S2, and an added signal of the first and second photoelectric conversion signals, that is, the image signal S3 are sequentially read out from the image sensor 22. Based on the readout first and second photoelectric conversion signals S1, S2 and values of the conversion factor k and the absorption ratio α recorded in a memory or the like in the body control unit 21, the body control unit 21 calculates a noise component (kaA+kaB).

The correction unit 211b subtracts the noise component (kaA+kaB) from the readout first photoelectric conversion signal S1 to generate the corrected first photoelectric conversion signal S1. Based on the corrected first photoelectric conversion signal S1 (for example, S1G', S1g'), the first focus detection unit 212a performs phase difference type focus detection calculation to calculate a defocus amount. Based on the second photoelectric conversion signal S2 (for example, S2G, S2g), the second focus detection unit 212b performs phase difference type focus detection calculation to calculate a defocus amount. Based on the corrected first photoelectric conversion signal S1 and the second photoelectric conversion signal S2, the third focus detection unit 212c performs phase difference type focus detection calculation to calculate a defocus amount. Based on the defocus amounts calculated by the first focus detection unit 212a to the third focus detection unit 212c, the lens control unit 32 moves the focus adjustment lens of the image-capturing optical system 31 to the focus position to adjust the focal point. Note that the image sensor 22 may be moved in the direction of the optical axis of the image-capturing optical system 31 for the focus adjustment, instead of moving the focus adjustment lens.

Based on the image signal S3 read out from the image sensor 22, the image data generation unit 211a generates image data for live-view image and actually photographed image data for recording. The image data for live-view image is displayed on the display unit 24, and the actually photographed image data for recording is recorded in the memory 23.

As the pixel miniaturizes, the opening of the pixel decreases. As a result, as the pixel miniaturizes, the size of the opening of the pixel becomes smaller (shorter) than a wavelength of light. Thus, in a focus detection pixel provided with a light shielding film at a light incident surface for performing phase difference detection, there is a possibility that the light does not enter the photoelectric conversion unit (photodiode). In the focus detection pixel with the light shielding film, it is more likely that red light does not enter the photoelectric conversion unit since light in a red wavelength region has a wavelength longer than that of light having other colors (green or blue). For this reason, in the focus detection pixel with the light shielding film, an amount of electric charges generated by photoelectric conversion in the photoelectric conversion unit is reduced, thereby making it difficult to perform focus detection for an optical system using the pixel signal. In particular, it is difficult to perform focus detection by photoelectric conversion of light having a long wavelength (red light and the like).

Regarding this point, in the present embodiment, the pixel provided with the reflection unit (reflection film) 43 is used, so that the opening of the pixel can be increased compared with that of the focus detection pixel with the light shielding film. As a result, in the present embodiment, focus detection can be performed even for light having a long wavelength since light having a long wavelength enters the photoelectric conversion unit. In this respect, the pixel provided with the reflection film 43 can be said to be a focus detection pixel suitable for long-wavelength region among wavelength regions of light subjected to photoelectric conversion in the image sensor 22. For example, in case the reflection films 43 are provided on any of the R, G, B pixels, the reflection films 43 may be provided on the R pixels.

According to the above-described embodiment, the following advantageous effects can be obtained.

(1) The image sensor 22 includes: the first pixel 10 having the micro lens 44 into which the first light flux 61 and the second light flux 62 having passed through the image-forming optical system 31 enter; the first photoelectric conversion unit 41 into which the first light flux 61 and the second light flux 62 having transmitted through the micro lens 44 enter; the reflection unit 43 that reflects the first light flux 61 having transmitted through the first photoelectric conversion unit 41 toward the first photoelectric conversion unit 41; and the second photoelectric conversion unit 42 into which the second light flux 62 having transmitted through the first photoelectric conversion unit 41 enters; and the second pixel 10 having the micro lens 44 into which the first light flux 61 and the second light flux 62 having passed through the image-forming optical system 31 enter; the first photoelectric conversion unit 41 into which the first light flux 61 and the second light flux 62 having transmitted through the micro lens 44 enter; the reflection unit 43 that reflects the second light flux 62 having transmitted through the first photoelectric conversion unit 41 toward the first photoelectric conversion unit 41; and the second photoelectric conversion unit 42 into which the first light flux 61 having transmitted through the first photoelectric conversion unit 41 enters. Thereby, phase difference information between an image formed by the first light flux 61 and an image formed by the second light flux 62 can be obtained by using the photoelectric conversion signals from the first pixel 10 (e.g., pixel 10G) and the second pixel 10 (e.g., pixel 10g).

(2) The first light flux 61 and the second light flux 62 are light fluxes respectively passing through a first region and a second region of the pupil of the image-forming optical system 31; and a position of the reflection unit 43 and a position of the pupil of the image-forming optical system 31 are in a conjugate positional relationship with respect to the micro lens 44. In this way, phase difference information between images formed by a pair of light fluxes enter through different pupil regions can be obtained.

(3) The image sensor 22 includes a first accumulation unit (first FD 15) that accumulates electric charge converted by the first photoelectric conversion unit 41; a second accumulation unit (second FD 16) that accumulates electric charge converted by the second photoelectric conversion unit 42; and connection units (connection units 51, 52) that connect the first accumulation unit and the second accumulation unit. Thereby, the electric charge converted by the first photoelectric conversion unit 41 and the electric charge converted by the second photoelectric conversion unit 42 can be added.

(4) The image sensor 22 includes a first transfer unit 11 that transfers the electric charge converted by the first photoelectric conversion unit 41, to the first accumulation unit (first FD 15); a second transfer unit 12 that transfers the electric charge converted by the second photoelectric conversion unit 42, to the second accumulation unit (second FD 16); and a control unit (pixel vertical drive unit 70) that controls the first transfer unit 11 and the second transfer unit 12 to perform a first control in which a signal based on the electric charge converted by the first photoelectric conversion unit 41 and a signal based on the electric charge converted by the second photoelectric conversion unit 42 are sequentially output, and a second control in which a signal based on electric charge obtained by adding the electric charge converted by the first photoelectric conversion unit 41 and the electric charge converted by the second photoelectric conversion unit 42. In this way, the first photoelectric conversion signal S1 and the second photoelectric conversion signal S2 can be sequentially outputted. Additionally, the electric charge generated by the first photoelectric conversion unit 41 and the electric charge generated by the second photoelectric conversion unit 42 can be added to output the image signal S3. Thus, all the pixels 10 provided in the image sensor 22 can be used as both the image-capturing pixel for generating the image signal and the focus detection pixel for generating the focus detection signal. As a result, each pixel 10 can be prevented from becoming a defective pixel as an image-capturing pixel.

(5) The focus detection apparatus includes the image sensor 22 and the focus detection unit (the first focus detection unit 212a) that performs focus detection of the image-forming optical system 31 based on a signal from the first photoelectric conversion unit 41 of the first pixel 10 and a signal from the first photoelectric conversion unit 41 of the second pixel 10. In this way, phase difference information between images formed by the first light flux 61 and the second light flux 62 can be obtained to perform focus detection of the image-capturing optical system 31.

(6) The focus detection apparatus includes the image sensor 22 and the focus detection unit (the second focus detection unit 212b) that performs focus detection of the image-forming optical system 31 based on a signal from the second photoelectric conversion unit 42 of the first pixel 10 and a signal from the second photoelectric conversion unit 42 of the second pixel 10. In this way, phase difference information between images formed by the first light flux 61 and the second light flux 62 can be obtained to perform focus detection of the image-capturing optical system 31.

(7) The focus detection apparatus includes: the image sensor 22; and the focus detection unit (the third focus detection unit 212c) that performs focus detection of the image-forming optical system 31 based on a signal from the first photoelectric conversion unit 41 of the first pixel 10 and a signal from the second photoelectric conversion unit 42 of the second pixel 10, and a signal from the second photoelectric conversion unit 42 of the first pixel 10 and a signal from the first photoelectric conversion unit 41 of the second pixel 10. In this way, phase difference information between images formed by the first light flux 61 and the second light flux 62 can be obtained to perform focus detection of the image-capturing optical system 31.

The following variations are also within the scope of the present invention, and one or more of the variations can be combined with the above-described embodiments.

First Variation

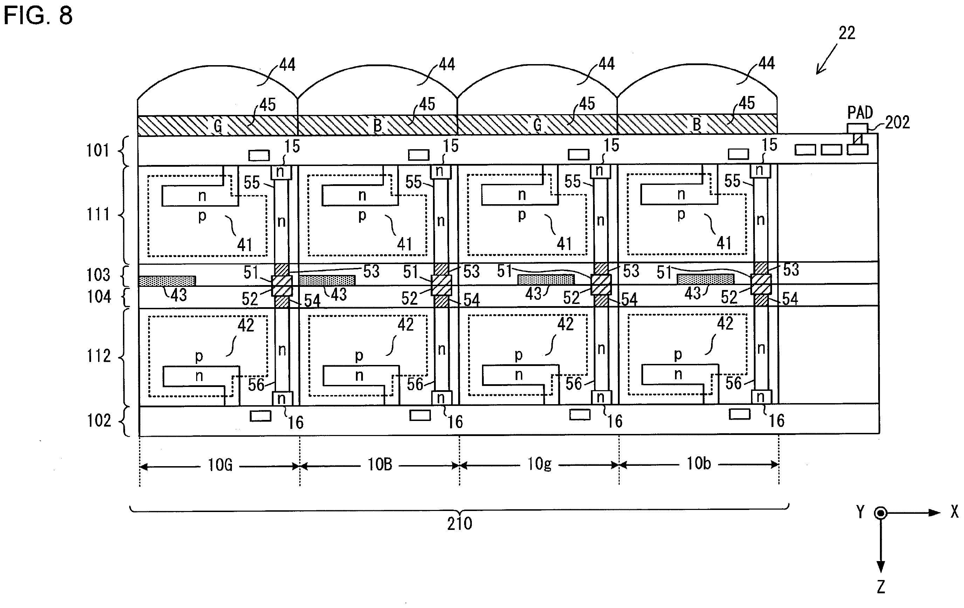

Fig. 8 is a view showing an example of a cross-sectional structure of an image sensor 22 according to a first variation. The image sensor of the first variation has a stack structure of the first substrate 111 and the second substrate 112 that is different from the structure of the image sensor of the first embodiment. The first substrate 111 has a wiring layer 101 and a wiring layer 103 stacked thereon and the second substrate 112 has a wiring layer 102 and a wiring layer 104 stacked thereon. The wiring layer 103 is provided with a connection unit 51 and a contact 53, and the wiring layer 104 is provided with a connection unit 52 and a contact 54.

The first substrate 111 is provided with a diffusion layer 55 formed using an n-type impurity, and the second substrate 112 is provided with a diffusion layer 56 formed using an n-type impurity. The diffusion layer 55 and the diffusion layer 56 are connected to the first FD 15 and the second FD 16, respectively. As a result, the first FD 15 and the second FD 16 are electrically connected via the diffusion layers 55, 56, the contacts 53, 54, and the connection units 51, 52.

In the first embodiment, as shown in Figs. 6 and 7, the signal of each pixel 10 is read out to the wiring layer 101 between the first substrate 111 and the second substrate 112. Therefore, in the first embodiment, it is necessary to provide a plurality of through electrodes 201 in order to read out the signal of each pixel 10 to the body control unit 21. In the first variation, the signal of each pixel 10 is read out to the wiring layer 101 above the first substrate 111. It is therefore unnecessary to provide the through electrodes 201, and the signal of each pixel 10 can be read out to the body control unit 21 through the electrode PAD 202.

Second Variation

In the first embodiment described above, in order to remove the noise component (kaA+kaB) from the first photoelectric conversion signal S1 by the correction unit 211b, the body control unit 21 calculates the noise component (kaA+kaB) based on the first photoelectric conversion signal S1 and the second photoelectric conversion signal S2. The second variation has a configuration of the image sensor 22 different from the configuration of the first variation. In the image sensor of the second variation, image-capturing pixels in which one photoelectric conversion unit is arranged under the micro lens 44 and the color filter 45 are scattered around each of the pixel groups 401 and 402 shown in Figs. 2 and 3. In this case, the body control unit 21 calculates (kaA+kaB) of expression (1) based on the photoelectric conversion signal of the image-capturing pixel and the correction unit 211b subtracts (kaA+kaB) from the first photoelectric conversion signal S1 of expression (1) to calculate the corrected photoelectric conversion signal S1, that is, $k(1-\alpha)A$. Similarly, the body control unit 21 calculates (kaA+kaB) of expression (3) based on the photoelectric conversion signal of the image-capturing pixel and the correction unit 211b subtracts (kaA+kaB) from the first photoelectric conversion signal S1 of expression (3) to calculate the corrected photoelectric conversion signal S1, that is, $k(1-\alpha)B$.

Third Variation

In the above-described embodiments, an example of a configuration has been described in which the discharge unit 17 and the amplification unit 18 are shared by the first photoelectric conversion unit 41 and the second photoelectric conversion unit 42 as shown in Fig. 5. However, the discharge unit 17 and the amplification unit 18 may be provided for each photoelectric conversion unit.

Fourth Variation

In the above-described embodiments and variations, an example has been described in which a photodiode is used as the photoelectric conversion unit. However, a photoelectric conversion film may be used as the photoelectric conversion unit.

Fifth Variation

Generally, a semiconductor substrate such as a silicon substrate used for the image sensor 22 has characteristics in which a transmittance varies depending on the wavelength of incident light. For example, light having a long wavelength (red light) is easy to transmit through the photoelectric conversion unit in comparison with light having a short wavelength (green light or blue light). Light having a short wavelength (green light or blue light) is hard to transmit through the photoelectric conversion unit in comparison with light having a long wavelength (red light). In other words, as for the light having a short wavelength, accessible depth is shallower than that of the light having a long wavelength, in the photoelectric conversion unit. Thus, the light having a short wavelength is subjected to photoelectric conversion in a shallow region of the semiconductor substrate, that is, a shallow portion of the photoelectric conversion unit (the negative Z direction side in Fig. 3), in the light incident direction (the Z-axis direction in Fig. 3). The light having a long wavelength is subjected to photoelectric conversion in a deep region of the semiconductor substrate, that is, a deep portion of the photoelectric conversion unit (the positive Z direction side in Fig. 3), in the light incident direction. From this point of view, a position (in the Z-axis direction) of the reflection film 43 may vary for each of R, G, B pixels. For example, in the B pixel, a reflection film may be arranged at a position shallower than that in the G pixel and the R pixel (a position on the negative Z direction side compared with the G pixel and the R pixel); in the G pixel, a reflection film may be arranged at a position deeper than that in the B pixel (a position on the positive Z direction side compared with the B pixel) and shallower than that in the R pixel (a position on the negative Z direction side compared with the R pixel); in the R pixel, a reflection film may be arranged at a position deeper than that in the G pixel and the B pixel (a position on the positive Z direction side compared with the G pixel and the B pixel).

Sixth Variation

Generally, the light having passed through the exit pupil of the image-capturing optical system 31 is substantially vertically enters the central portion of the image-capturing surface of the image sensor 22, whereas light is obliquely enters a peripheral portion located outward from the central portion, that is, a region away from the center of the image-capturing surface. Therefore, the reflection film 43 of each pixel may be configured to have different area and position depending on the position (for example, the image height) of the pixel in the image sensor 22. Moreover, the position and the exit pupil distance of the exit pupil of the image-capturing optical system 31 are respectively different between in the central portion and in the peripheral portion of the image-capturing surface of the image sensor 22. From this point of view, the reflection film 43 of each pixel may be configured to have different area and position depending on the position and the exit pupil distance of the exit pupil. Thereby, the amount of light enters the photoelectric conversion unit through the image-capturing optical system 31 can be increased. Further, even when light is obliquely enters the image sensor 22, pupil splitting can be appropriately performed in accordance with the condition.

Seventh Variation

The image sensor 22 described in the above-described embodiments and variations may also be applied to a camera, a smartphone, a tablet, a PC built-in camera, a vehicle-mounted camera, a camera mounted on an unmanned plane (drone, radio-controlled plane, etc.), and the like.

Although various embodiments and variations have been described above, the present invention is not limited to these embodiments and variations. Other aspects contemplated within the technical idea of the present invention are also encompassed within the scope of the present invention.

The disclosure of the following priority application is herein incorporated by reference:
Japanese Patent Application No. 2016-192252 (filed September 29, 2016)

REFERENCE SIGNS LIST

2 ... camera body, 3 ... interchangeable lens, 21 ... body control unit, 22 ... image sensor, 31 ... image-capturing optical system, 41 ... first photoelectric conversion unit, 42 ... second photoelectric conversion unit, 43 ... reflection unit, 44 ... microlens, 211a ... image data generation unit, 211b ... correction unit, 212a ... first focus detection unit, 212b ... second focus detection unit, 212c ... third focus detection unit

**Claims**

1.   An image sensor, having a first pixel and a second pixel arranged therein,
     the first pixel comprises: a microlens into which a first light flux and a second light flux having passed through an image-forming optical system enter; a first photoelectric conversion unit into which the first light flux and the second light flux having transmitted through the microlens enter; a reflection unit that reflects the first light flux having transmitted through the first photoelectric conversion unit toward the first photoelectric conversion unit; and a second photoelectric conversion unit into which the second light flux having transmitted through the first photoelectric conversion unit enters; and

a second pixel comprises: a microlens into which a first light flux and a second light flux having passed through an image-forming optical system enter; a first photoelectric conversion unit into which the first light flux and the second light flux having transmitted through the microlens enter; a reflection unit that reflects the second light flux having transmitted through the first photoelectric conversion unit toward the first photoelectric conversion unit; and a second photoelectric conversion unit into which the first light flux having transmitted through the first photoelectric conversion unit enters.

2. The image sensor according to claim 1, wherein:

the first light flux and the second light flux are light fluxes respectively having passed through a first region and a second region of the pupil of the image-forming optical system; and

with respect to each of the first pixel and the second pixel, a position of the reflection unit and a position of the pupil of the image-forming optical system are in a conjugate positional relationship with respect to the microlens.

3. The image sensor according to claim 1 or 2, further comprising:

a first accumulation unit that accumulates electric charge generated by the first photoelectric conversion unit;

a second accumulation unit that accumulates electric charge generated by the second photoelectric conversion unit; and

a connection unit that connects the first accumulation unit and the second accumulation unit.

4. The image sensor according to claim 3, further comprising:

a first transfer unit that transfers the electric charge having converted by the first photoelectric conversion unit to a first accumulation unit;

a second transfer unit that transfers the electric charge having converted by the second photoelectric conversion unit to a second accumulation unit; and

a control unit that controls the first transfer unit and the second transfer unit to perform a first control in which a signal based on the electric charge having converted by the first photoelectric conversion unit and a signal based on the electric charge having converted by the second photoelectric conversion unit are sequentially output; and a second control in which a signal is output, the signal being based on electric charge obtained by adding the electric charge having converted by the first photoelectric conversion unit and the electric charge having converted by the second photoelectric conversion unit.

5. The image sensor according to any one of claims 1 to 4, further comprising:

a first substrate provided with the first photoelectric conversion unit; and

a second substrate stacked on the first substrate and provided with the second photoelectric conversion unit, wherein:

the reflection unit is provided between the first photoelectric conversion unit and the second photoelectric conversion unit.

6. A focus detection apparatus, comprising:

the image sensor according to any one of claims 1 to 5; and

a focus detection unit that performs focus detection of the image-forming optical system based on a signal from the first photoelectric conversion unit of the first pixel and a signal from the first photoelectric conversion unit of the second pixel.

7. A focus detection apparatus, comprising:

the image sensor according to any one of claims 1 to 5; and

a focus detection unit that performs focus detection of the image-forming optical system based on a signal from the second photoelectric conversion unit of the first pixel and a signal from the second photoelectric conversion unit of the second pixel.

8. A focus detection apparatus, comprising:

the image sensor according to any one of claims 1 to 5; and

a focus detection unit that performs focus detection of the image-forming optical system based on a signal from the first photoelectric conversion unit of the first pixel and a signal from the second photoelectric conversion unit of the second pixel, and a signal from the second photoelectric conversion unit of the first pixel and a signal from the first photoelectric conversion unit of the second pixel.

9. An electronic camera, comprising:

the image sensor according to any one of claims 1 to 5; and
a correction unit that corrects, based on a signal from the second photoelectric conversion unit, a signal from the first photoelectric conversion unit.

10. An electronic camera, comprising:

the image sensor according to any one of claims 1 to 5; and
an image generation unit that generates image data based on a signal from the first photoelectric conversion unit of the image sensor and a signal from the second photoelectric conversion unit of the image sensor.

11. The electronic camera according to claim 10, wherein:
the image generation unit generates an added signal obtained by adding a signal from the first photoelectric conversion unit of the image sensor and a signal from the second photoelectric conversion unit of the image sensor.

## FIG. 1

FIG. 2

FIG. 3

EP 3 522 225 A1

# FIG. 4

| | FIRST G PIXEL 10G1 | SECOND G PIXEL 10g1 | FIRST G PIXEL 10G2 | SECOND G PIXEL 10g2 | ... |
|---|---|---|---|---|---|
| FIRST PHOTOELECTRIC CONVERSION SIGNAL S1' | $k(1-\alpha)A1$ | $k(1-\alpha)B2$ | $k(1-\alpha)A3$ | $k(1-\alpha)B4$ | ... |
| SECOND PHOTOELECTRIC CONVERSION SIGNAL S2 | $k(1-\alpha)B1$ | $k(1-\alpha)A2$ | $k(1-\alpha)B3$ | $k(1-\alpha)A4$ | ... |

EP 3 522 225 A1

## FIG. 5

FIG. 6

FIG. 7

FIG. 8

## INTERNATIONAL SEARCH REPORT

| International application No. |
|---|
| PCT/JP2017/035750 |

### A. CLASSIFICATION OF SUBJECT MATTER

Int.Cl.   H01L27/146(2006.01)i,   G02B7/34(2006.01)i,   G03B13/36(2006.01)i,
          H04N5/232(2006.01)i,   H04N5/347(2011.01)i,   H04N5/369(2011.01)i,
          H04N5/374(2011.01)i

According to International Patent Classification (IPC) or to both national classification and IPC

### B. FIELDS SEARCHED

Minimum documentation searched (classification system followed by classification symbols)

Int.Cl.   H01L27/146, G02B7/34, G03B13/36, H04N5/232, H04N5/347, H04N5/369,
          H04N5/374

Documentation searched other than minimum documentation to the extent that such documents are included in the fields searched

| | |
|---|---|
| Published examined utility model applications of Japan | 1922–1996 |
| Published unexamined utility model applications of Japan | 1971–2017 |
| Registered utility model specifications of Japan | 1996–2017 |
| Published registered utility model specifications of Japan | 1994–2017 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2016-127043 A (SONY CORP.) 11 July 2016, paragraphs [0122]-[0225], fig. 11-18 (Family: none) | 1-11 |
| A | JP 2014-183206 A (SONY CORP.) 29 September 2014, paragraphs [0047]-[0130], fig. 9-39 & US 2014/0285627 A1; paragraphs [0047]-[0188], fig. 9-39 & CN 104065894 A | 1-11 |

☒ Further documents are listed in the continuation of Box C.        ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 December 2017 (11.12.2017) | 19 December 2017 (19.12.2017) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

| International application No. |
|---|
| PCT/JP2017/035750 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2016-62996 A (TOSHIBA CORP.) 25 April 2016, paragraphs [0092]-[0186], fig. 4-26 7 US 2016/0079464 A1; paragraphs [0116]-[0210], fig. 4-26 | 1-11 |
| A | JP 2014-130231 A (CANON INC.) 10 July 2014, entire text, all drawings (Family: none) | 1-11 |
| A | JP 2015-194706 A (CANON INC.) 05 November 2015, entire text, all drawings & US 2015/0281556 A1 | 1-11 |
| A | WO 2016/103365 A1 (OLYMPUS CORP.) 30 June 2016, entire text, all drawings & US 2017/0221956 A1 | 1-11 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010177704 A

- JP 2016192252 A